Europäisches Patentamt

European Patent Office

Office européen des brevets

(19)

(11) Numéro de publication: **0 005 096**
**B1**

(12) **FASCICULE DE BREVET EUROPEEN**

(45) Date de publication du fascicule de brevet: **16.12.81**

(51) Int. Cl.³: **H 03 B 7/14**

(21) Numéro de dépôt: **79400216.2**

(22) Date de dépôt: **03.04.79**

(54) Source d'ondes millimétriques.

(30) Priorité: **14.04.78 FR 7811059**

(43) Date de publication de la demande:
**31.10.79 Bulletin 79/22**

(45) Mention de la délivrance du brevet:
**16.12.81 Bulletin 81/50**

(84) Etats Contractants Désignés:
**BE DE GB IT LU NL SE**

(56) Documents cités:
**FR - A - 2 183 016**
**FR - A - 2 348 574**
**US - A - 3 465 265**
**US - A - 3 524 149**
**US - A - 3 659 222**
**US - A - 3 996 529**

**IBM TECHNICAL DISCLOSURE BULLETIN, vol. 8, n° 8, janvier 1966, New York**
**FLEMING: "Electronic FM Modulation of GaAs Oscillator", page 1077../.**

(73) Titulaire: **THOMSON-CSF**
**173, Boulevard Haussmann**
**F-75360 Paris Cedex 08 (FR)**

(72) Inventeur: **Cachier, Gérard**
**"THOMSON CSF"-SCPI 173, bld Haussmann**
**F-75360 Paris Cedex 08 (FR)**
Inventeur: **Stevance, Jean**
**"THOMSON-CSF"-SCPI 173, bld Haussmann**
**F-75360 Paris Cedex 08 (FR)**

(74) Mandataire: **Giraud, Pierre et al,**
**"THOMSON-CSF" - SCPI 173, bld Haussmann**
**F-75360 Paris Cedex 08 (FR)**

(56) Documents cités:
**IEEE TRANSACTIONS ON MICROWAVE THEORY AND TECHNIQUES, vol. 24, n° 10, octobre 1976, New York**
**JOHNSON: "Posttuning Drift of a Transferred-Electron-Device Voltage-Controlled Oscillator", pages 650—656.**

**INTERELECTRONIQUE, n° 232, 31 janvier 1977, Paris**
**DELLA MUSSIA: "L'intégration gagne les composants hyperfréquences millimétriques", pages 19—22.**

Courier Press, Leamington Spa, England.

Source d'ondes millimétriques

L'invention concerne une source d'ondes millimétriques à l'état solide, dans laquelle on a intégré un composant semiconducteur actif qui est une diode oscillatrice entourée de matériau diélectrique. Ce diélectrique est localisé entre un support métallique du composant servant également à la fois de contact de polarisation et de paroi supérieure d'une cavité résonnante dont la paroi inférieure est le support métallique, d'où le nom de module préaccordé donné à ce type de source en raison du fait que la cavité privilégie l'oscillation sur une fréquence particulière.

Un problème souvent posé est celui de l'utilisation d'une telle source dans un émetteur dont on peut faire varier la fréquence pour répondre à certains besoins en réalisant les fonctions suivantes:

— la modulation de la fréquence d'oscillation de la diode, soit du type numérique (application à la transmission de données) soit du type analogique (application à la mesure de distance par effet Doppler);

— le réglage automatique de la fréquence d'oscillation de la diode (application aux télécommunications).

On a proposé de réaliser ces fonctions en agissant sur le courant d'alimentation de la diode, en utilisant le phénomène par ailleurs indésirable, de la dépendance de la fréquence vis-à-vis de la polarisation de la diode. Les inconvénients d'un tel procédé sont multiples, car l'effet produit est assez limité, notamment dans le cas du module préaccordé, mais aussi difficilement maîtrisable, et variable d'un échantillon à l'autre de diode à avalanche. En outre, il est accompagné d'une modulation d'amplitude importante, non désirée, et nécessite généralement un compromis sur la puissance de sortie. Enfin, il est incompatible avec une fréquence élevée de modulation.

On a proposé enfin, dans un article de J. P. DELLA MUSSIA, intitulé: "L'intégration gagne les composants hyperfréquence", publié dans la revue INTERELECTRONIQUE, n° 232 du 31 janvier 1977, pages 21 et 22, un système de source "modulable" dans lequel une diode à capacité variable est placée dans le même module préaccordée que la diode oscillatrice. A cet effet, la partie supérieure du module est divisée en deux parties, formant deux demi-disques juxtaposés par leurs sections diamétrales. La diode à capacité variable et la diode oscillatrice sont situées chacune sur un demi-disque, au voisinage de la section diamétrale de manière à présenter une certaine capacité mutuelle. Elles sont alimentées séparément. En modifiant la tension d'alimentation de la diode à capacité variable on fait varier la fréquence d'accord d'un circuit comprenant les deux demi-disques du module et leur capacité mutuelle. Toutefois ce système est assez complexe et de performances limitées par la relative petitesse de la capacité mutuelle des deux diodes.

L'invention permet de résoudre le problème posé plus haut en évitant la plupart des inconvénients précités.

La source d'ondes millimétriques selon le préambule comporte au minimum:

— un premier module (actif) constitué, comme il a été indiqué précédemment, par une diode entourée de matériau diélectrique, diode dont une électrode de polarisation est une métallisation plane déposée sur une face du matériau diélectrique.

— un deuxième module (passif) semblable au premier, placé de manière à rapprocher autant que possible, sans les mettre en contact mutuel, les métallisations planes des deux modules:

— des moyens de polarisation permettant de faire fonctionner l'un des modules en oscillateur et l'autre en diode à capacité variable.

Selon l'invention les métallisations des deux modules sont placés en regard les unes des autres par leurs faces frontales et sont séporées par une lame de diélectrique assurant la couplage des modules en haute fréquence.

L'invention sera mieux comprise et d'autres caractéristiques apparaitront, au moyen de la description qui suit, en se reportant aux dessins qui l'accompagnent, parmi lesquels:

— la figure 1 est un schéma d'une source selon l'invention;

— la figure 2 représente une réalisation de l'invention en guide d'ondes à section rectangulaire;

— la figure 3 représente partiellement une variante de la réalisation précédente;

— la figure 4 est une vue en plan d'un détail qui est représenté en coupe à la figure 3;

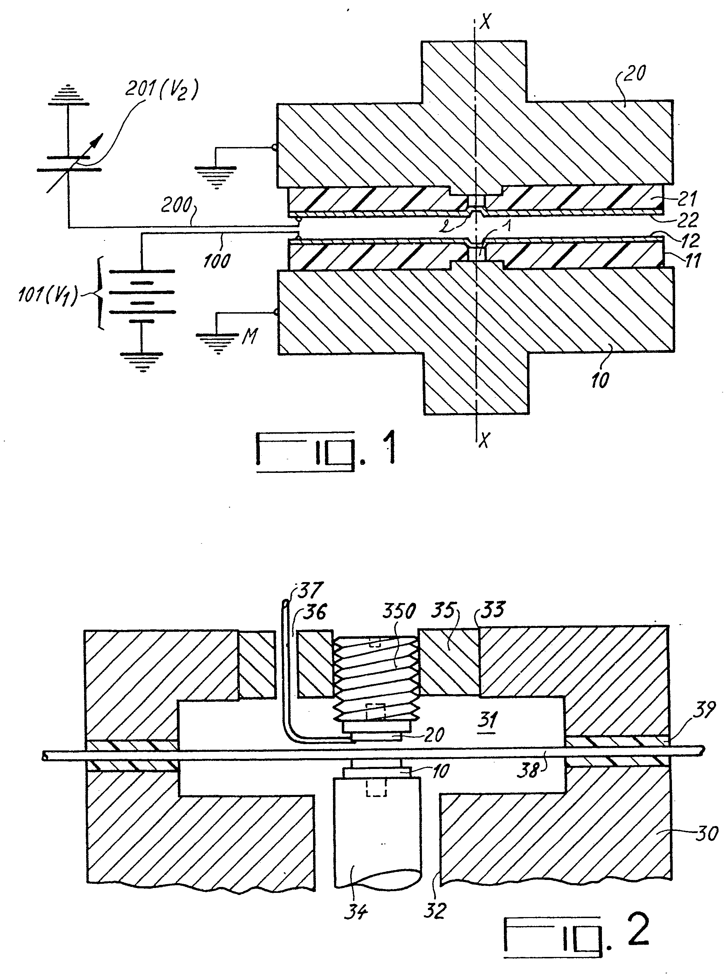

A titre d'exemple, deux modules identiques ont été représentés figure 1, dans un schéma théorique d'un dispositif selon l'invention où les métallisations planes des deux modules sont parallèles et placées en regard l'une de l'autre à faible distance (de l'ordre du millimètre ou moins).

Ces deux modules présentent respectivement sur des supports 10 et 20 de dissipation thermique, des diodes 1 et 2, entourées de matériau diélectrique (11, 21) recouvert d'une métallisation plane et circulaire (12, 22). Ces deux modules sont des solides de révolution dont les axes sont confondus, avec une même droite XX.

Une connexion 100 est soudée à la métallisation 20 qu'elle relie à une source d'alimentation 201 à tension variable $V_2$. Le support 20 est relié à la masse.

La tension $V_1$ est déterminée pour un fonctionnement en oscillatrice de la diode 1 à la puissance désirée (module actif).

Le repère 201 désigne une source de polarisation variable; il peut s'agir d'une alimentation réglée par un potentiomètre aussi bien que d'une sortie d'un dispositif de modulation par tension variable. Cette source polarise le module passif.

Une explication possible du phénomène qui est à la base de l'invention est la suivante:

On trouve entre les deux supports 10 et 20 un système comportant en série:

— le diélectrique 11 recouvert de la métallisation 12, celle-ci étant reliée électriquement au support 10 à travers la diode 1;

— une lame d'air;

— le diélectrique 21 recouvert de la métalisation 22, celle-ci étant reliée électriquement au support 20 à travers la diode 2.

Un tel système se prête à des calculs relativement simples en considérant, de manière simplifiée, qu'il s'agit de trois circuits micro-ondes en série, la lame d'air étant équivalente à une cavité de couplage. Le résultat de ces calculs conduit à l'expression approximative ci-après, dans laquelle on appelle $\Delta f$ l'excursion de la fréquence d'oscillation lorsqu'on fait varier de $\Delta C$ la capacité C de la diode à capacité variable, les surtensions respectives du circuit et de la diode oscillatrice étant appelées $Q_1$ et $Q_2$:

$$\frac{\Delta f}{f} = \frac{1}{2} \times \frac{Q_2}{Q_1} \times \frac{\Delta C}{C} \times \frac{C}{C_d}$$

où $C_d$ est la capacité de la diode 1 (oscillatrice). L'excursion de fréquence peut atteindre 1 GHz pour $f = 50$ GHz.

Dans l'exemple de réalisation représenté figure 2, un tronçon de guide 30, placé entre deux brides de raccordement (non représentées) comporte des parois plus épaisses que le reste du guide d'ondes, notamment sur l'un des grands côtés de la cavité 31, de section rectangulaire.

Une première ouverture 32, pratiquée dans la paroi d'un grand côté de la cavité 31, permet le coulissement d'une pièce de positionnement cylindrique 34 (partiellement représentée) dont le diamètre est modifiable par un dispositif d'écartement non représenté. A l'extrémité de cette pièce, un module 10 est fixé par un embout fileté de son support vissé dans un trou taraudé de la pièce 34.

Une deuxième ouverture 33, pratiquée dans la paroi de la cavité opposée à l'ouverture 32, permet l'introduction en force d'une pièce 35. Cette pièce est traversée par un noyau 350 se vissant au centre de la pièce 35. Le noyau porte un module 20 fixé par un embout fileté de son support au noyau 350. En outre, la pièce 35 comporte une lumière 36 permettant le passage d'une connexion isolée 37 reliée par soudure à la métallisation du module 20. Le module 10 est polarisé par contact de sa métallisation avec un conducteur 38 tendu entre deux passages 39 à travers les deux parois latérales de la cavité 31.

Une première variante de réalisation consiste à supprimer le conducteur 38 et à remplacer le système de positionnement et de polarisation du module 10 par un système identique à celui du module 20.

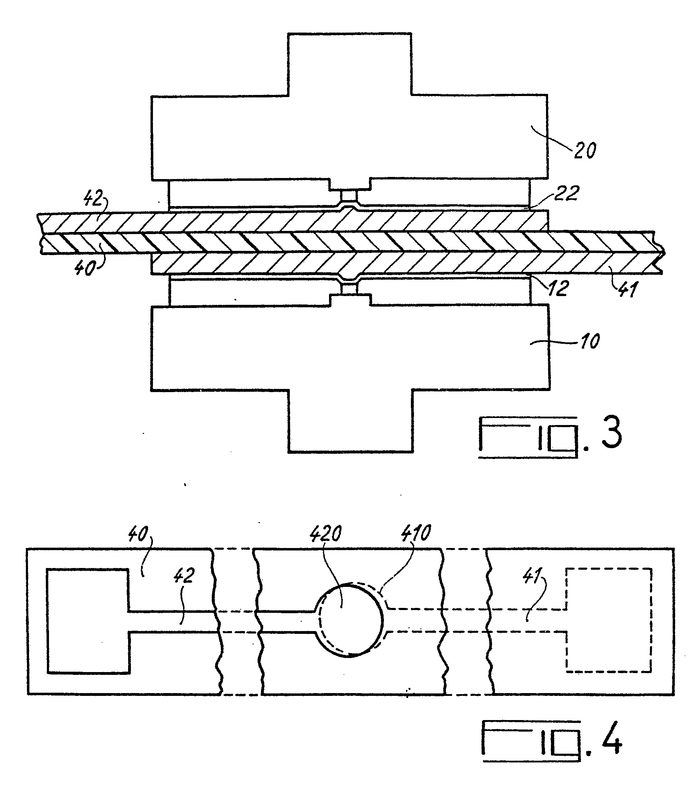

Une deuxième variante de réalisation consiste à adopter pour les systèmes de positionnement des modules 10 et 20 un système identique à celui du module 10. En ce qui concerne la polarisation, elle est obtenue en utilisant un câblage imprimé à double face représenté en plan à la figure 4. Ce câblage imprimé prend la place du conducteur 38, les passages 39 étant modifiés en conséquence. Les métallisations 41 et 42 présentent des parties circulaires 410 et 420 destinées à entrer en contact avec les métallisations 12 et 22 (figure 3). Des rondelles métalliques (non représentées) peuvent être intercalées entre les pièces 12 et 410, 22 et 420 pour ajuster la fréquence centrale d'oscillation.

Dans une variante de réalisation non représentée, la source est placée dans un logement constituant une dérivation d'un tronçon de guides d'ondes. La position de la source dans le logement est réglable. En outre, un piston mobile disposé dans une extrémité du tronçon permet d'accorder l'impédance du tronçon de guide d'ondes à l'endroit de la dérivation constituée par le logement où est placée la source.

L'invention est notamment applicable aux sources d'ondes millimétriques comportant une diode oscillatrice du type diode à avalanche. La diode à capacité variable du module associé à la diode oscillatrice peut être éventuellement constituée par une jonction semiconductrice différente de celle qui est utilisée dans la diode oscillatrice.

## Revendications

1. Source d'ondes millimétriques, du type comportant un module actif (1) constitué par une première diode, un disque (11) de diélectrique solide entourant la diode, une première électrode (10) jouant le rôle de support, et une métallisation (12) jouant le rôle d'électrode de polarisation la source comportant en outre des moyens de polarisation capables de faire fonctionner la première diode en diode à résistance négative à haute fréquence, et un module passif (2) constitué par une deuxième diode (2), capable de fonctionner, dans des conditions déterminées de polarisation comme diode à capacité variable un disque (21) de diélectrique solide entourant la diode, une première électrode (20) jouant le rôle de support, et une métallisation (22) jouant le rôle d'électrode de polarisation, caractérisé en ce que les métallisations (12, 22) des deux modules sont placées en regard les unes des autres par leurs faces frontales et sont séparées par une lame diélectrique (38) assurant le couplage des modules en haute fréquence.

2. Source suivant la revendication 1, caractérisé en ce que les deux modules sont situés dans un tronçon de guide d'ondes (31) où sont pratiquée des passages pour des pièces de positionnement des deux modules et pour les connexions de polarisation.

3. Source suivant la revendication 2, caractérisé en ce que le module actif (1) et le module passif (2) sont respectivement en contact avec deux conducteurs (41, 42) appartenant aux faces opposées d'un câblage imprimé à double face.

4. Source suivant la revendication 1, caractérisé en ce qu'elle comporte en outre un tronçon de guide d'ondes (31), le module actif (1) étant supporté par une première pièce (34) mise en place dans une première paroi du tronçon et polarisé par un premier conducteur (38) isolé, le module passif (2) étant supporté par une deuxième paroi du tronçon et polarisé par un deuxième conducteur (37) isolé, la masse électrique commune (30) groupant les deux pièces et les parois du tronçon.

5. Source suivant la revendication 1, caractérisé en ce qu'elle est placée dans une position réglable dans un logement constituant une dérivation d'un tronçon de guide d'ondes, celui-ci comportant en outre un piston mobile.

## Patentansprüche

1. Quelle für Millimeterwellen, desjenigen Typs, der einen aktiven, durch eine erste Diode gebildeten Modul (1), eine die Diode umgebende dielektrische Feststoffscheibe (11), eine erste, die Aufgabe einer Halterung erfüllende Elektrode (10) und eine Metallisierung (12) umfaßt, welche die Aufgabe der Polarisationselektrode erfüllt, wobei die Quelle ferner Polarisierungsmittel, welche imstande sind, die erste Diode bei Hochfrequenz als eine Diode mit negativem Widerstand arbeiten zu lassen, und einen passiven, durch eine zweite Diode gebildeten Modul (2) umfaßt, der unter bestimmten Polarisierungsbedingungen als Diode mit veränderlicher Kapazität arbeiten kann, dadurch gekennzeichnet, daß die Metallisierungen (12, 22) der beiden Moduln mit ihren Stirnseiten einander gegenüber angeordnet und durch eine dielektrische Scheibe (38) getrennt sind, welche die Kopplung der Moduln bei Hochfrequenz gewährleistet.

2. Quelle nach Anspruch 1, dadurch gekennzeichnet, daß die beiden Moduln in einem Wellenleiterabschnitt (31) angeordnet sind, in dem Durchgänge für Positionierungsteile der zwei Moduln und für die Polarisierungsanschlüsse angebracht sind.

3. Quelle nach Anspruch 2, dadurch gekennzeichnet, daß der aktive Modul (1) und der passive Modul (2) jeweils in Berührung mit einem von zwei Leitern (41, 42) sind, die zu den einander gegenüberliegenden Flächen einer doppelseitigen gedruckten Schaltung gehören.

4. Quelle nach Anspruch 1, dadurch gekennzeichnet, daß sie ferner einen Wellenleiterabschnitt (31) umfaßt, wobei der aktive Modul (1) von einem ersten Teil (34) gehaltert ist, das in einer ersten Wandung des Abschnittes angeordnet ist, und durch einen ersten isolierten Leiter (38) polarisiert ist, wobei der passive Modul (2) von einer zweiten Wandung des Abschnittes gehaltert ist und durch einen zweiten isolierten Leiter (37) polarisiert wird, während die gemeinsame elektrische Masse (30) die zwei Teile und die Wandungen des Abschnitts gruppiert.

5. Quelle nach Anspruch 1, dadurch gekennzeichnet, daß sie in einer einstellbaren Lage in einem Aufnahmeraum angeordnet ist, der eine Abzweigung eines Wellenleiterabschnittes bildet, welcher ferner einen beweglichen Kolben umfaßt.

## Claims

1. Millimeter wave source of the type comprising an active module (1) formed by a first diode, a disk (11) of a dielectric solid surrounding the diode, a first electrode (10) having the function of a support, and a metallisation (12) having the function of the polarizing electrode, the source further comprising polarizing means capable of making operate the first diode as a diode with negative resistance at high frequency, and a passive module (2) formed by a second diode capable of operating as a diode having variable capacity under determined conditions, characterized in that the metallisations (12, 22) of the two modules are placed with their front faces one facing the other and are separated by a dielectric plate (38) assuring the coupling of the modules at high frequency.

2. Source in accordance with claim 1, characterized in that the two modules are placed within a wave guide section (31) in which passages are formed for the positioning parts of the two modules and for the polarizing connections.

3. Source in accordance with claim 2, characterized in that the active module (1) and the passive module (2) are respectively in contact with two conductors (41, 42) belonging to the opposed faces of a double-sided printed circuit.

4. Source in accordance with claim 1, characterized in that it further comprises a wave guide section (31), the active module (1) being supported by a first part (34) placed in a first wall of the section and polarized by a first insulated conductor (38), the passive module (2) being supported by a second wall of the section and polarized by a second insulated conductor (37), the common electric ground

7        **0 005 096**        8

(30) grouping the two parts and the walls of the section.

5. Source in accordance with claim 1, characterized in that it is placed in an adjustable position in a lodgement forming a branch of the wave guide section, the latter further comprising a movable piston.

Fig. 1

Fig. 2

FIG. 3

FIG. 4